# EUROPEAN PATENT APPLICATION

(11) **EP 4 757 526 A1**
(43) Date of publication of application: **10.06.2026**
(21) Application number: 25203963.1
(22) Date of filing: 23.09.2025
(51) Int. Cl.: H10D 1/68, H10B 12/00

(54) **CAPACITOR INCLUDING DIELECTRIC LAYER INCLUDING HIGH-K MATERIAL, ELECTRONIC DEVICE INCLUDING THE CAPACITOR, AND METHOD OF MANUFACTURING THE CAPACITOR**

(30) Priority: 03.12.2024 KR 20240177588
(71) Applicant: Samsung Electronics Co., Ltd., Suwon-si, Gyeonggi-do 16677 (KR)
(72) Inventor: KIM, Jinhong, 16678 Suwon-si (KR); LEE, Changsoo, 16678 Suwon-si (KR); KIM, Sunghyun, 16678 Suwon-si (KR); LEE, Jaeho, 16678 Suwon-si (KR)
(74) Representative: Elkington and Fife LLP

(57) **Abstract**

Provided are a capacitor including a dielectric layer including a high-k material and an electronic device including the same. The capacitor includes a first electrode, a second electrode facing the first electrode, a dielectric layer between the first electrode and the second electrode, and a conductive interface layer between the first electrode and the dielectric layer. The dielectric layer includes a dielectric material having a rutile crystalline phase. The dielectric layer includes a first intermediate layer and a second intermediate layer which are provided in the dielectric layer. The first intermediate layer includes an oxide of metal having p-type characteristics. The second intermediate layer includes an oxide of a Group IV metal element having a rutile crystalline phase.

## Description

### FIELD OF THE INVENTION

The disclosure relates to a capacitor including a dielectric layer including a high-k material, an electronic device including the capacitor, and a method of manufacturing the capacitor.

### BACKGROUND OF THE INVENTION

As the degree of integration of electronic devices, such as memories, increases, electronic elements in the electronic devices are becoming smaller. However, because the capacitance of a capacitor is proportional to the area of the capacitor, the capacitance may decrease as the size of the capacitor is reduced. Therefore, in order to compensate for the decrease in size of a capacitor and secure a desired capacitance, studies have been conducted on a method of further increasing a dielectric constant of a dielectric layer. In addition, studies have been conducted on a method of suppressing an increase in leakage current due to miniaturization of capacitors.

### SUMMARY OF THE INVENTION

Provided are a capacitor including a dielectric layer including a high-k material and an electronic device including the capacitor.

Provided are a capacitor with improved leakage current characteristics and an electronic device including the capacitor.

Additional aspects will be set forth in part in the description which follows and, in part, will be apparent from the description, or may be learned by practice of the presented some example embodiments of the disclosure.

According to an aspect of the disclosure, a capacitor includes a first electrode, a second electrode facing the first electrode, a dielectric layer between the first electrode and the second electrode, the dielectric layer comprising a dielectric material having a rutile crystalline phase, and a conductive interface layer between the first electrode and the dielectric layer, wherein the dielectric layer includes a first intermediate layer and a second intermediate layer in the dielectric material, the first intermediate layer includes an oxide of at least one of aluminum (Al), gallium (Ga), yttrium (Y), lanthanum (La), boron (B), indium (In), or scandium (Sc), and the second intermediate layer includes an oxide of a Group IV metal element having a rutile crystalline phase.

Proposals may provide a TiO₂ based DRAM capacitor structure and methods of operating the same, and methods of fabricating the same. Embodiments may be implemented in the form of a chip and may be mounted as a capacitor in next-generation DRAM.

According to some example embodiments, it is intended to use p-type dopants such as Al₂O₃, and a tetravalent oxide at the same time as the intercalation film. The tetravalent oxide plays a role in capturing oxygen vacancies that are abundant in TiO₂. This makes it possible to eliminate the Fermi level pinning caused by vacancies. Securing sufficient conduction band offset by using a conductive interface film with a large work function is the most important factor for materials with a small bandgap, such as TiO₂ dielectric films. If Fermi level pinning occurs at this time, the high work function of the electrode film is not expressed. The tetravalent oxide intercalation film plays a key role in controlling this.

Embodiments may provide a capacitor structure in which a multilayer interface film is inserted between a dielectric film and a lower electrode film in the structure of a MIM capacitor.

For example, the dielectric material of the dielectric layer may include titanium oxide (TiO₂) having the rutile crystalline phase.

A content of a metal of the first intermediate layer in the dielectric layer may be greater than 0 at% and about 20 at% or less.

The oxide of the second intermediate layer may include an oxide of at least one of germanium (Ge), silicon (Si), or tin (Sn).

A content of a metal of the second intermediate layer in the dielectric layer may be about 0.1 at% or more and about 10 at% or less.

The second intermediate layer may have a thickness of about 0.1 nm or more and about 0.5 nm or less.

A thickness of the second intermediate layer may be less than a thickness of the first intermediate layer.

A gap between the conductive interface layer and the second intermediate layer may be 0.5 nm or more.

The second intermediate layer may be between the first intermediate layer and the conductive interface layer.

The first intermediate layer may be between the second intermediate layer and the conductive interface layer.

The conductive interface layer may include a first conductive interface layer between the first electrode and the dielectric layer, and a second conductive interface layer between the first conductive interface layer and the dielectric layer, the first conductive interface layer may include a conductive metal oxide material having a stable crystal structure in a rutile crystalline phase, and a conduction band offset (CBO) between the second conductive interface layer and the dielectric layer may be greater than a CBO between the first conductive interface layer and the dielectric layer.

The first conductive interface layer may include molybdenum oxide (MoO₂) doped with tin (Sn).

An Sn doping concentration in the first conductive interface layer may be about 0.1 at% or more and about 10 at% or less.

The first conductive interface layer may have a thickness of about 0.3 nm or more and about 4 nm or less.

The second conductive interface layer may include tin oxide (SnO₂), germanium oxide (GeO₂), or a mixture ((SnₓGe₁₋ₓ)O₂, 0<x<1) of tin oxide and germanium oxide.

The second conductive interface layer may have a thickness of about 0.3 nm or more and about 1 nm or less.

The first electrode may include at least one of titanium nitride (TiN), vanadium nitride (VN), niobium nitride (NbN), tantalum nitride (TaN), molybdenum nitride (MoN), and cobalt nitride (CoN), or any combination thereof.

According to another aspect of the disclosure, provided is an electronic device including a transistor and a capacitor electrically connected to the transistor, wherein the capacitor includes a first electrode, a second electrode facing the first electrode, and a dielectric layer between the first electrode and the second electrode, the dielectric layer including a first metal oxide, a second metal oxide, and a third metal oxide, the first metal oxide includes titanium oxide having a rutile crystalline phase, the second metal oxide includes an oxide of at least one of aluminum (Al), gallium (Ga), yttrium (Y), lanthanum (La), boron (B), indium (In), or scandium (Sc), and the third metal oxide includes an oxide of at least one of germanium (Ge), silicon (Si), or tin (Sn).

A content of the second metal oxide and a content of the third metal oxide in the dielectric layer may be different from each other.

According to another aspect of the disclosure, provided is a method of manufacturing a capacitor, the method including forming a conductive interface layer on a first electrode, forming a dielectric layer on the conductive interface layer, the dielectric layer including a first metal oxide, a second metal oxide, and a third metal oxide, and forming a second electrode on the dielectric layer, wherein the first metal oxide includes titanium oxide having a rutile crystalline phase, the second metal oxide includes an oxide of at least one of aluminum (Al), gallium (Ga), yttrium (Y), lanthanum (La), boron (B), indium (In), or scandium (Sc), and the third metal oxide includes an oxide of at least one of germanium (Ge), silicon (Si), or tin (Sn).

### BRIEF DESCRIPTION OF THE DRAWINGS

The above and other aspects, features, and advantages of certain some example embodiments of the disclosure will be more apparent from the following description taken in conjunction with the accompanying drawings, in which:
FIG. 1 is a cross-sectional view illustrating a schematic structure of a capacitor according to at least one example embodiment;
FIG. 2 is a schematic energy band diagram showing an example of a conduction band offset (CBO) between a second conductive interface layer and a dielectric layer in the capacitor illustrated in FIG. 1;
FIGS. 3A to 3D are cross-sectional views schematically illustrating a process of forming a conductive interface layer of the capacitor illustrated in FIG. 1;
FIG. 4 shows a high resolution-transmission electron microscopy (HR-TEM) image of an actually manufactured capacitor according to an example;
FIG. 5 is a graph showing an example of an ultraviolet (UV) photoelectron spectroscopy (UPS) spectrum obtained through UPS measurement for the first conductive interface layer;
FIG. 6 is a graph showing a comparison of leakage current characteristics between a capacitor including a conductive interface layer according to an example and a capacitor including a conductive interface layer according to a comparative example;
FIG. 7 is a graph showing a comparison of leakage current characteristics between capacitors according to a content of tin (Sn) in a first conductive interface layer;
FIG. 8 shows an example of a grazing incidence X-ray diffraction (GI-XRD) measurement result showing a comparison of crystallinity between dielectric layers grown in various layer structures;
FIG. 9 is a graph showing a comparison of leakage current characteristics of a capacitor according to various contents of materials of a first intermediate layer and a second intermediate layer;
FIG. 10 is a graph showing a comparison of leakage current characteristics of the capacitor according to the thickness of the second intermediate layer;
FIG. 11 is a graph showing a comparison of leakage current characteristics of the capacitor according to the position of the second intermediate layer;
FIG. 12 is a cross-sectional view illustrating a schematic structure of a capacitor according to at least one example embodiment;
FIG. 13 is a circuit diagram for describing a schematic circuit configuration and operation of an electronic device including a capacitor, according to some example embodiments;
FIG. 14 is a schematic diagram illustrating an electronic device according to at least one example embodiment;
FIG. 15 is a schematic diagram illustrating an electronic device according to at least one example embodiment;
FIG. 16 is a plan view illustrating an electronic device according to at least one example embodiment;
FIG. 17 is a cross-sectional view of the electronic device taken along line A-A' of FIG. 16;
FIG. 18 is a cross-sectional view illustrating an electronic device according to at least one example embodiment; and
FIGS. 19 and 20 are conceptual diagrams schematically illustrating a device architecture applicable to a device according to at least one example embodiment.

### DETAILED DESCRIPTION

Reference will now be made in detail to some example embodiments, examples of which are illustrated in the accompanying drawings, wherein like reference numerals refer to like elements throughout. In this regard, the present embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a capacitor including a dielectric layer including a high-k material and an electronic device including the same are described in detail with reference to the attached drawings. In the following drawings, the same reference numerals denote the same elements, and the size of each element in the drawings may be exaggerated for clarity and convenience of explanation. In addition, embodiments described herein are merely examples, and various modifications may be made thereto from these embodiments. Additionally, when the terms "about" or "substantially" are used in this specification in connection with a numerical value and/or geometric term, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

Hereinafter, the terms "above," "on," "below," or "under" may include not only those that are directly above, below, left, or right in a contact manner, but also those that are above, below, left, or right in a non-contact manner. Additionally, spatially relative terms, such as above, below, etc. are represented herein based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly. The singular forms as used herein are intended to include the plural forms as well unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order.

Also, the terms such as "unit" and "module" described in the specification mean units that are configured to process at least one function or operation, and may be implemented as processing circuitry such as hardware, software, or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC), a programmable logic unit, a microprocessor, or an application-specific integrated circuit (ASIC), etc., unless expressly indicated otherwise.

Connecting lines or connecting members illustrated in the drawings are intended to represent exemplary functional relationships and/or physical or logical connections between the various elements. It should be noted that many alternative or additional functional relationships, physical connections or logical connections may be present in a practical device.

The use of all illustrations or illustrative terms in the some example embodiments is simply to describe the technical ideas in detail, and the scope of the inventive concept is not limited by the illustrations or illustrative terms unless they are limited by claims.

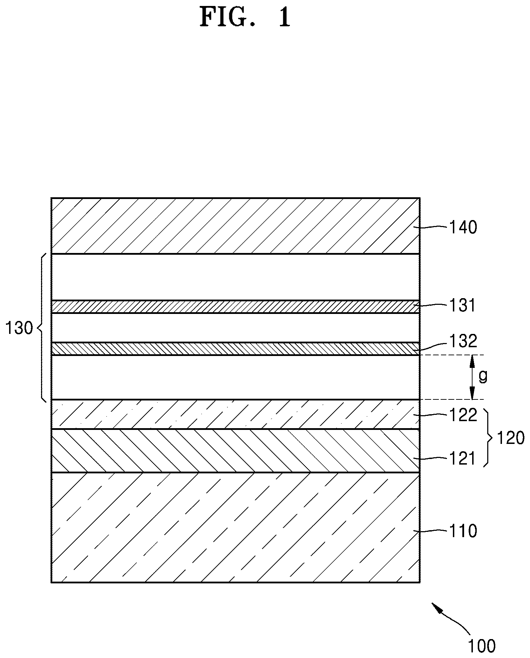

FIG. 1 is a cross-sectional view illustrating a schematic structure of a capacitor 100 according to at least one example embodiment. Referring to FIG. 1, the capacitor 100 according to at least one example embodiment includes a first electrode 110, a second electrode 140 facing the first electrode 110, a dielectric layer 130 between the first electrode 110 and the second electrode 140, and a conductive interface layer 120 between the first electrode 110 and the dielectric layer 130. In other words, the dielectric layer 130 may be provided between the first electrode 110 and the second electrode 140 facing each other. In a process of manufacturing the capacitor 100, the conductive interface layer 120 may be formed on an upper surface of the first electrode 110, the dielectric layer 130 may be formed on an upper surface of the conductive interface layer 120, and the second electrode 140 may be formed on an upper surface of the dielectric layer 130.

The dielectric layer 130 may include a dielectric material having a rutile crystalline phase. The expression "the dielectric layer 130 includes a dielectric material having a rutile crystalline phase" means that the dielectric layer 130 includes a dielectric material in which the rutile crystalline phase is dominant. In other words, the entire dielectric material need not have the rutile crystalline phase, most of the dielectric material may have the rutile crystalline phase, and/or the rutile crystalline phase may occupy the largest portion among the crystalline phases of the materials forming the dielectric material. Hereinafter, the material having the rutile crystalline phase refers to a material in which the rutile crystalline phase is dominant.

For example, the dielectric layer 130 may include titanium oxide (TiO₂) having a rutile crystalline phase. The titanium oxide has a different dielectric constant depending on a phase of the titanium oxide. While titanium oxide having an anatase crystalline phase has a dielectric constant of about 40, titanium oxide having a rutile crystalline phase may have a great dielectric constant of about 80 to about 170 depending on a growth direction of the titanium oxide. Accordingly, the dielectric layer 130 including titanium oxide having a rutile crystalline phase may have a dielectric constant of about 80 to about 170. According to at least one example embodiment, because the dielectric layer 130 has a high dielectric constant, the thickness of the dielectric layer 130 may be reduced and the capacitor 100 may be further miniaturized. For example, the dielectric layer 130 may have a thickness of about 3 nanometers (nm) to about 7 nm.

The first electrode 110 may include a conductive metal nitride. In particular, the first electrode 110 may include a metal nitride that is not easily reduced to metal during a heat treatment process. In other words, the metal nitride may be thermally stable within the higher temperature ranges applied during heat treatment processes (as discussed in further detail below). For example, the first electrode 110 may include at least one conductive metal nitride selected from titanium nitride (TiN), vanadium nitride (VN), niobium nitride (NbN), tantalum nitride (TaN), molybdenum nitride (MoN), cobalt nitride (CoN), and/or any combination thereof. The first electrode 110 may have a thickness of about 5 nm to about 10 nm.

The second electrode 140 includes a conductive material. A material of the second electrode 140 is not particularly limited. For example, the second electrode 140 may include a conductive material having a single-layer structure and/or a multilayer structure including a metal, a metal nitride, a metal oxide, and/or any combination thereof. The second electrode 140 may include, for example, at least one of titanium nitride (TiN), molybdenum nitride (MoN), cobalt nitride (CoN), tantalum nitride (TaN), tungsten (W), ruthenium (Ru), ruthenium oxide (RuO₂), iridium (Ir), iridium oxide (IrO₂), platinum (Pt), platinum oxide (PtO), BaRuO₃, SrRuO₃ (SRO), (Ba,Sr)RuO₃ (BSRO), CaRuO₃ (CRO), (La,Sr)CoO₃ (LSCO), and/or any combination thereof.

The conductive interface layer 120 may be configured to enable (e.g., induce through lattice strain, and/or preferential lattice growth through crystal alignment) the dielectric layer 130 having a rutile crystalline phase to be grown thereon and to reduce leakage current. According to at least one example embodiment, the conductive interface layer 120 may include a first conductive interface layer 121 on the upper surface of the first electrode 110 and a second conductive interface layer 122 on the upper surface of the first conductive interface layer 121. The dielectric layer 130 may be provided on the upper surface of the second conductive interface layer 122. Therefore, the first conductive interface layer 121 may be provided between the first electrode 110 and the dielectric layer 130, and in particular, between the first electrode 110 and the second conductive interface layer 122, and the second conductive interface layer 122 may be provided between the first conductive interface layer 121 and the dielectric layer 130.

The first conductive interface layer 121 may include a conductive metal oxide material having a stable crystal structure in the rutile crystalline phase so that the dielectric layer 130 having a rutile crystalline phase may be grown on the conductive interface layer 120. In addition, the first conductive interface layer 121 may include a conductive metal oxide material that is not easily reduced to metal during a heat treatment process. The first conductive interface layer 121 may also include a conductive metal oxide material that has a relatively high work function while having little deterioration of film quality during a crystallization process (e.g., 450 °C or more, as discussed in further detail below). The first conductive interface layer 121 may include, for example, molybdenum oxide (MoO₂) doped with tin (Sn). In other words, the first conductive interface layer 121 may include both molybdenum oxide (MoO₂) and tin oxide (SnO₂). Therefore, the first conductive interface layer 121 may also be referred to as a "molybdenum oxide (MoO₂) layer doped with Sn" provided between one of the two electrodes 110 and 140 and between the first electrode 110 and the dielectric layer 130.

Like the first conductive interface layer 121, the second conductive interface layer 122 may include a conductive metal oxide material having a stable crystal structure in a rutile crystalline phase. In addition, the second conductive interface layer 122 may include a conductive metal oxide material that has a relatively high conduction band offset (CBO) with the dielectric layer 130 so as to reduce leakage current. For example, the material of the second conductive interface layer 122 may be selected so that the CBO between the second conductive interface layer 122 and the dielectric layer 130 is greater than the CBO between the first conductive interface layer 121 and the dielectric layer 130. The second conductive interface layer 122 may include, for example, tin oxide (SnO₂), germanium oxide (GeO₂), and/or a mixture ((SnₓGe₁₋ₓ)O₂, 0<x<1) of tin oxide and germanium oxide. Accordingly, the second conductive interface layer 122 may also be referred to as an "interface layer including tin oxide and/or germanium oxide" provided between the "molybdenum oxide (MoO₂) layer doped with Sn" and the dielectric layer 130.

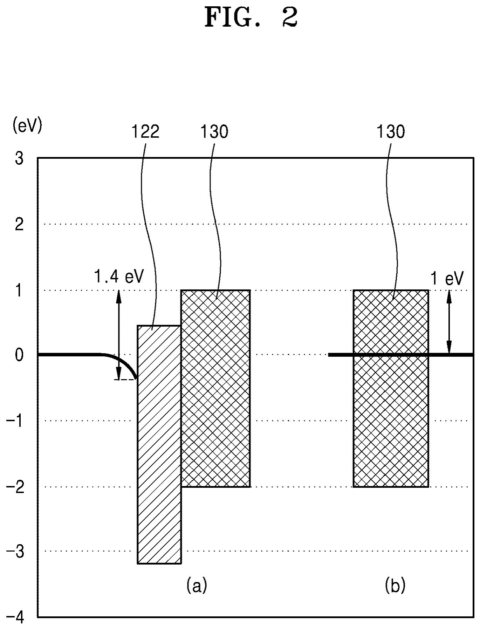

FIG. 2 is a schematic energy band diagram showing an example of the CBO between the second conductive interface layer 122 and the dielectric layer 130 in the capacitor 100 illustrated in FIG. 1. (a) of FIG. 2 shows an example of the CBO between the second conductive interface layer 122 and the dielectric layer 130, and (b) of FIG. 2 shows an example of the CBO between the first conductive interface layer 121 and the dielectric layer 130 when the second conductive interface layer 122 does not exist for comparison. In FIG. 2, the conduction band of the first conductive interface layer 121 is indicated by a thick solid line. Referring to FIG. 2, the CBO between the second conductive interface layer 122 and the dielectric layer 130 may be greater than about 1 eV. For example, the CBO between the second conductive interface layer 122 and the dielectric layer 130 may be about 1.4 eV, and/or about 1.4 eV or more and about 1.5 eV or less. On the other hand, the CBO between the first conductive interface layer 121 and the dielectric layer 130 may be about 1 eV, which is less than the CBO between the second conductive interface layer 122 and the dielectric layer 130.

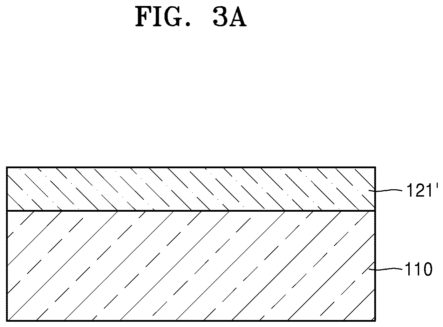

FIGS. 3A to 3D are cross-sectional views schematically illustrating a process of forming the conductive interface layer 120 of the capacitor 100 illustrated in FIG. 1.

Referring to FIG. 3A, a first material layer 121' including amorphous molybdenum oxide (MoOₓ) may be formed on an upper surface of a first electrode 110. The first material layer 121' may be formed through, for example, pulsed laser deposition (PLD) or atomic layer deposition (ALD). Alternatively, the first material layer 121' may be formed through other deposition methods, such as chemical vapor deposition (CVD) or physical vapor deposition (PVD).

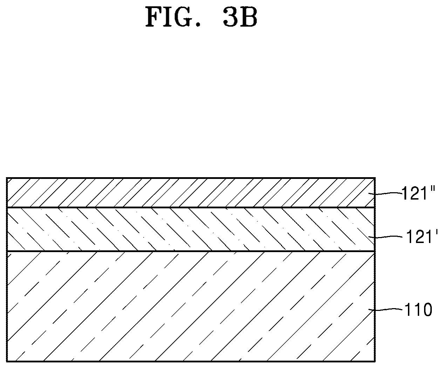

Referring to FIG. 3B, a second material layer 121" including tin oxide (SnO₂) may be formed on an upper surface of the first material layer 121'. For example, the second material layer 121" may be formed through ALD.

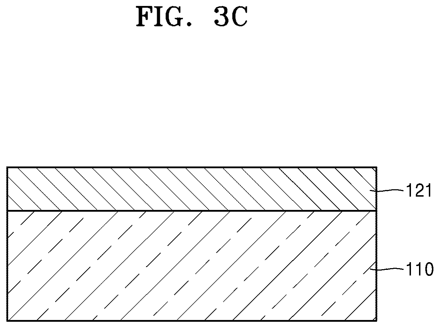

Referring to FIG. 3C, the first material layer 121' may be crystallized through post metallization annealing (PMA). The PMA may be performed at a temperature of, for example, about 450 °C or more and/or about 600 °C or less. The amorphous molybdenum oxide (MoOₓ) may be crystallized to form crystalline molybdenum oxide (MoO₂). In this process, tin oxide (SnO₂) of the second material layer 121" on the first material layer 121' may be mixed in the crystal structure of the crystalline molybdenum oxide (MoO₂). Then, the first conductive interface layer 121 including crystalline molybdenum oxide (MoO₂) doped with Sn and/or including both crystalline molybdenum oxide (MoO₂) and crystalline tin oxide (SnO₂) may be formed on the upper surface of the first electrode 110. The first conductive interface layer 121 may have a thickness of about 0.3 nm or more and about 4 nm or less, and/or about 0.3 nm or more and about 3 nm or less.

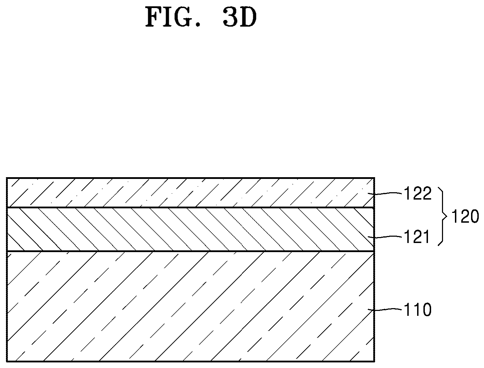

Referring to FIG. 3D, a second conductive interface layer 122 may be formed on the first conductive interface layer 121. In this manner, the conductive interface layer 120 may be completed. For example, the second conductive interface layer 122 may be formed on the first conductive interface layer 121 by growing crystalline tin oxide (SnO₂), crystalline germanium oxide (GeO₂), or a mixture ((SnₓGe₁₋ₓ)O₂, 0<x<1) of crystalline tin oxide and crystalline germanium oxide on the first conductive interface layer 121 through ALD. The second conductive interface layer 122 may have a thickness of about 0.3 nm or more and about 1 nm or less, and/or about 0.3 nm or more and about 0.6 nm or less. For example, in at least some example embodiments, the thickness of the second conductive interface layer 122 may be such that the lattice structure of the first conductive interface layer 121 constrain the lattice structure of the second conductive interface layer 122, thereby enabling the structure of the first conductive interface layer 121 to affect the structure of the dielectric layer 130 through the second conductive interface layer 122.

After the process of FIG. 3D, a dielectric layer 130 may be formed on the conductive interface layer 120, particularly the second conductive interface layer 122, and a second electrode 140 may be formed on the dielectric layer 130. In this manner, the capacitor 100 may be manufactured. For example, the dielectric layer 130 may be formed by depositing titanium oxide (TiO₂) through ALD. The dielectric layer 130 including titanium oxide (TiO₂) having a rutile crystalline phase may be implemented by depositing titanium oxide (TiO₂) through ALD on the conductive interface layer 120 having a stable crystal structure in a rutile crystalline phase.

According to at least one example embodiment, in the process of forming the first conductive interface layer 121, film quality deterioration of crystallized molybdenum oxide (MoO₂) may be alleviated by doping Sn when crystallizing amorphous molybdenum oxide (MoOₓ). Accordingly, the conductive interface layer 120 may have a relatively uniform thickness of about 4 nm or less, and the surface roughness of the conductive interface layer 120 may be relatively small. In this case, the dielectric layer 130 may be formed homogeneously on the conductive interface layer 120 and leakage current may be reduced.

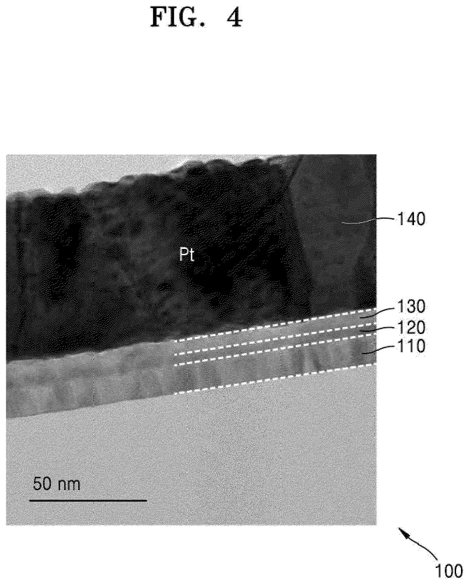

FIG. 4 shows a high resolution-transmission electron microscopy (HR-TEM) image of an actually manufactured capacitor according to an example. A first electrode 110 was formed of titanium nitride (TiN), a conductive interface layer 120 was formed of molybdenum oxide (MoO₂) doped with Sn and tin oxide (SnO₂), a dielectric layer 130 was formed of titanium oxide (TiO₂) having a rutile crystalline phase, and a second electrode 140 was formed of platinum (Pt). Although not clearly visible in the image, the conductive interface layer 120 may include both a first conductive interface layer 121 and a second conductive interface layer 122. The first electrode 110, the conductive interface layer 120 and the dielectric layer 130 were grown through ALD. The second electrode 140 was formed by an evaporator. Referring to FIG. 4, the conductive interface layer 120 according to at least one example embodiment has a relatively uniform thickness. Therefore, in the case of the conductive interface layer 120 according to the embodiment, the film quality deterioration of molybdenum oxide (MoO₂) is alleviated due to Sn doped into molybdenum oxide (MoO₂). Accordingly, the dielectric layer 130 on the conductive interface layer 120 may also have a relatively uniform thickness.

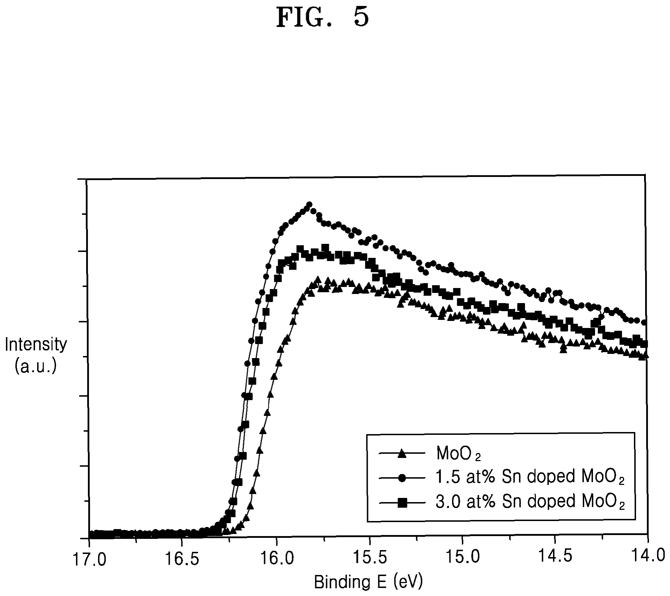

FIG. 5 is a graph showing an example of an ultraviolet (UV) photoelectron spectroscopy (UPS) spectrum obtained through UPS measurement for the first conductive interface layer 121. The UPS spectrum illustrated in FIG. 5 is obtained by forming the 3-nm-thick first conductive interface layer 121 on the 10-nm-thick first electrode 110 formed of titanium nitride (TiN) and irradiating the first conductive interface layer 121 with UV light of about 21.22 eV in a vertical direction. In the graph of FIG. 5, the horizontal axis represents binding energy and the vertical axis represents the intensity or kinetic energy of electrons ejected by a photoelectric effect. A work function of a sample may be obtained from a difference between 21.22 eV and an X intercept value of a differentiated value for the UPS spectrum graph illustrated in FIG. 5.

For example, the work function of the first conductive interface layer according to the comparative example, which is undoped with Sn, is about 5.12 eV. In addition, the work function of the first conductive interface layer 121 according to the example, which is doped with Sn at a concentration of about 1.5 at%, is about 5.02 eV, and the work function of the first conductive interface layer 121 according to the example, which is doped with Sn at a concentration of about 3.0 at%, is about 5.03 eV. Therefore, the work function of the first conductive interface layer 121 according to the example, which is doped with Sn, is slightly lower than the work function of the first conductive interface layer according to the comparative example, which is undoped with Sn.

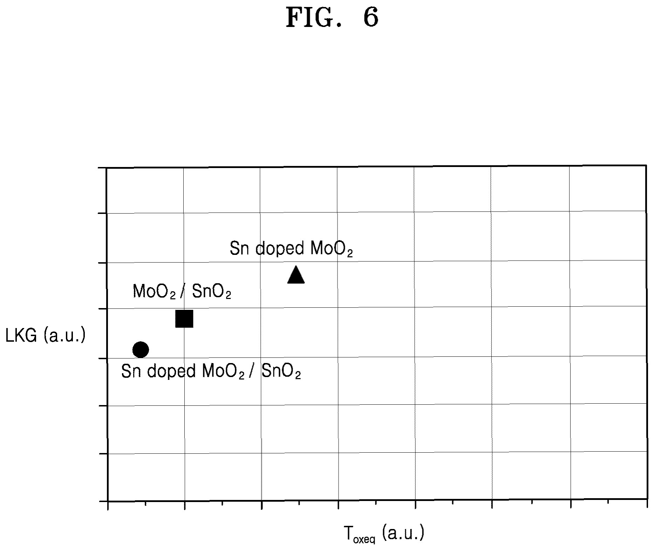

FIG. 6 is a graph showing a comparison of leakage current characteristics between the capacitor 100 including the conductive interface layer 120 according to the example and the capacitor including the conductive interface layer according to the comparative example. In FIG. 6, the horizontal axis represents the equivalent oxide thickness of the dielectric layer and the vertical axis represents the leakage current of the capacitor. In the graphs of FIG. 6 and FIGS. 7, 9, 10, and 11 described below, the numerical values of the equivalent oxide thickness and the leakage current on the horizontal axis and the vertical axis are normalized to show only relative characteristics. Referring to FIG. 6, leakage current of a capacitor according to Comparative Example 1 (A), which includes only the first conductive interface layer formed of MoO₂ doped with Sn at a concentration of 1.5 at% and does not include the second conductive interface layer, is the greatest, and the equivalent oxide thickness thereof is also the greatest. Leakage current and equivalent oxide thickness of a capacitor according to Comparative Example 2 (■), which includes the first conductive interface layer formed of MoO₂ undoped with Sn and the second conductive interface layer formed of SnO₂, may be smaller than leakage current and equivalent oxide thickness of the capacitor according to Comparative Example 1. In addition, the leakage current and equivalent oxide thickness of the capacitor 100 according to the example (●), which includes both the first conductive interface layer 121 formed of MoO₂ doped with Sn at a concentration of 1.5 at% and the second conductive interface layer 122 formed of SnO₂, are the smallest.

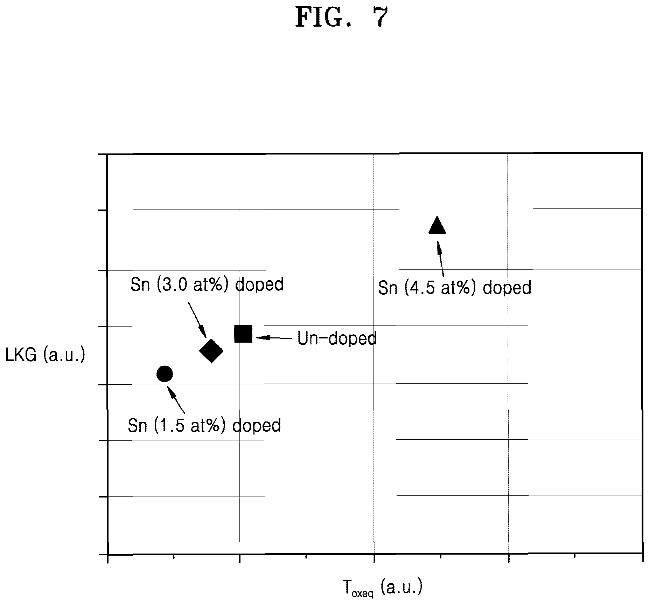

FIG. 7 is a graph showing a comparison of leakage current characteristics between the capacitors 100 according to the content of Sn in the first conductive interface layer 121. Referring to FIG. 7, when the Sn doping concentration in the first conductive interface layer 121 is about 1.5 at% (●), the leakage current and equivalent oxide thickness of the capacitor 100 are the smallest. The leakage current and equivalent oxide thickness of the capacitor 100 (◆) in which the Sn doping concentration in the first conductive interface layer 121 is about 3.0 at% are slightly greater than the leakage current and equivalent oxide thickness of the capacitor 100 in which the Sn doping concentration in the first conductive interface layer 121 is about 1.5 at%, but are smaller than the leakage current and equivalent oxide thickness of the capacitor according to the comparative example (■). On the other hand, the leakage current and equivalent oxide thickness of the capacitor 100 (▲) in which the Sn doping concentration in the first conductive interface layer 121 is about 4.5 at% are greater than the leakage current and equivalent oxide thickness of the capacitor according to the comparative example.

When comprehensively considering a change in various characteristics according to a change in the Sn doping concentration in the first conductive interface layer 121 observed through FIGS. 5 to 7, the Sn doping concentration in the first conductive interface layer 121 may be about 0.1 at% or more and about 5.0 at% or less. Alternatively, the Sn doping concentration in the first conductive interface layer 121 may be about 0.1 at% or more and about 4.0 at% or less, about 0.1 at% or more and about 3.0 at% or less, about 0.5 at% or more and about 3.0 at% or less, or about 1.5 at% or more and about 3.0 at% or less. The Sn doping concentration in the first conductive interface layer 121 may be a ratio of the number of Sn atoms to the total number of metal atoms in the first conductive interface layer 121. In other words, the Sn doping concentration in the first conductive interface layer 121 may be "100 × the number of Sn atoms/(the number of Sn atoms + the number of Mo atoms)."

As described above, in the case of the capacitor 100 according to the example embodiment, the dielectric layer 130 including a dielectric material having a rutile crystalline phase may be formed through ALD by using the first conductive interface layer 121 doped with Sn. Accordingly, the disclosed capacitor 100 may be miniaturized and have high capacitance. In addition, because the material of the first electrode 110 is chemically stable, the material of the first electrode 110 is unlikely to be reduced to a metal in a subsequent process. In addition, the leakage current may be reduced by using the second conductive interface layer 122 having a sufficiently large CBO with the dielectric layer 130.

Referring again to FIG. 1, the dielectric layer 130 includes a first intermediate layer 131 and a second intermediate layer 132 which are provided in the dielectric layer 130. Titanium oxide (TiO₂) having a rutile crystalline phase has a relatively high dielectric constant, but has a relatively small band gap of about 3.0 eV and has electrically n-type characteristics, which may cause leakage current to occur. The first intermediate layer 131 may include an oxide of a dopant metal having electrically p-type characteristics. For example, the first intermediate layer 131 may include an oxide of at least one metal selected from aluminum (Al), gallium (Ga), yttrium (Y), lanthanum (La), boron (B), indium (In), and scandium (Sc). The first intermediate layer 131 having electrically p-type characteristics is configured to reduce leakage current by lowering a Fermi level of the dielectric layer 130. However, because the first intermediate layer 131 does not have a rutile crystalline phase, the titanium oxide (TiO₂) of the dielectric layer 130 may be grown into an anatase crystalline phase rather than a rutile crystalline phase when the amount of the first intermediate layer 131 increases. By taking this into consideration, the content of the dopant metal of the first intermediate layer 131 in the dielectric layer 130 may be, for example, greater than 0 at% and about 20 at% or less. The content of the dopant metal may be a ratio of the number of dopant metal atoms to the total number of metal atoms in the dielectric layer 130 including the metal of the second intermediate layer 132 described below.

The second intermediate layer 132 may include an oxide of a Group IV metal element that may have a rutile crystalline phase. For example, the second intermediate layer 132 may include an oxide of at least one of germanium (Ge), silicon (Si), and/or tin (Sn). Germanium oxide (GeO₂), silicon oxide (SiO₂), and tin oxide (SnO₂) may have thermodynamically stable properties in the rutile crystalline phase. In particular, germanium oxide (GeO₂) may have the greatest band gap (e.g., about 4.63 eV) among oxides having a rutile crystalline phase, which may compensate for a relatively small band gap of titanium oxide (TiO₂). The second intermediate layer 132 may help the dielectric layer 130 grow into a rutile crystalline phase. In addition, the second intermediate layer 132 may reduce the number of oxygen vacancies in the dielectric layer 130 by capturing oxygen vacancies existing in the dielectric layer 130. Therefore, the leakage current may be further reduced by suppressing Fermi-level pinning that occurs at the interface between the conductive interface layer 120 and the dielectric layer 130 due to a large number of oxygen vacancies distributed in the dielectric layer 130.

The first intermediate layer 131 and the second intermediate layer 132 may be grown through ALD during the process of growing the dielectric layer 130. For example, a lower portion of the dielectric layer 130 may be grown through ALD, and the second intermediate layer 132 may be grown through ALD. After that, the dielectric layer 130 may be partially grown again on the second intermediate layer 132, the first intermediate layer 131 may be grown on the dielectric layer 130 through ALD, and then, an upper portion of the dielectric layer 130 may be grown on the first intermediate layer 131. Thicknesses of the first intermediate layer 131 and the second intermediate layer 132 may vary depending on the contents of the first intermediate layer 131 and the second intermediate layer 132 in the dielectric layer 130.

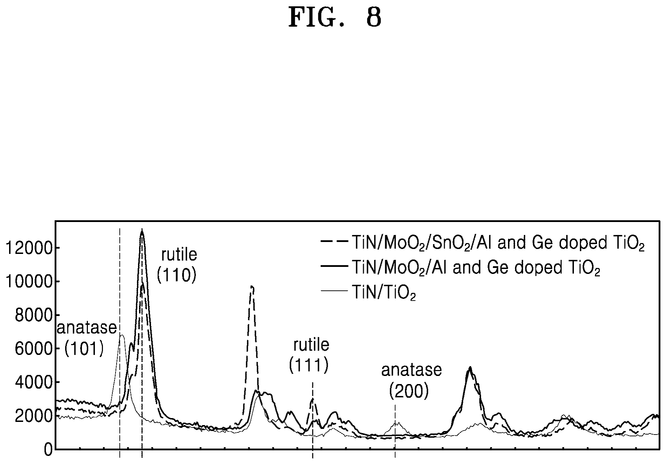

FIG. 8 shows an example of a grazing incidence X-ray diffraction (GI-XRD) measurement result showing a comparison of crystallinity between dielectric layers grown in various layer structures. Referring to FIG. 8, titanium oxide (TiO₂) grown on titanium nitride (TiN) mainly has an anatase crystalline phase. On the other hand, when a conductive interface layer including molybdenum oxide (MoO₂) exists between titanium nitride (TiN) and the dielectric layer 130, titanium oxide (TiO₂) having a rutile crystalline phase may be well grown even when the dielectric layer 130 includes the first intermediate layer 131 and the second intermediate layer 132. In particular, when tin oxide (SnO₂) is further added on molybdenum oxide (MoO₂) as the conductive interface layer, the orientation in the c-axis direction with relatively high dielectric constant increases.

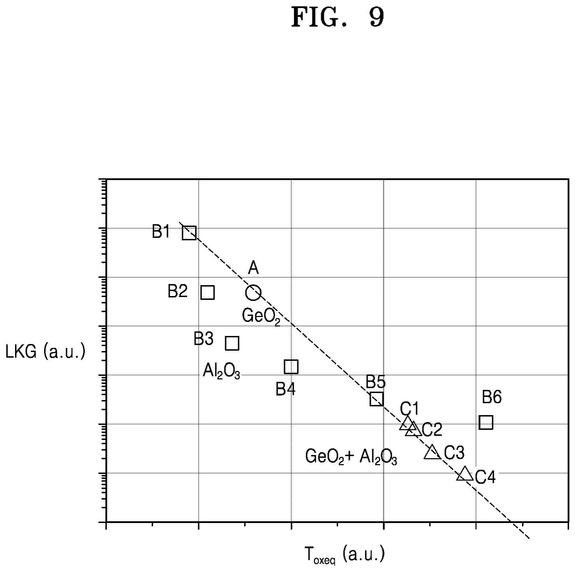

FIG. 9 is a graph showing a comparison of leakage current characteristics of a capacitor according to various contents of materials of the first intermediate layer 131 and the second intermediate layer 132. The dielectric layer 130 used titanium oxide (TiO₂) having a thickness of 5 nm, the first intermediate layer 131 used aluminum oxide (Al₂O₃), and the second intermediate layer 132 used germanium oxide (GeO₂). The first electrode 110 used titanium nitride (TiN), the first conductive interface layer 121 used molybdenum oxide (MoO₂) doped with Sn, and the second conductive interface layer 122 used tin oxide (SnO₂). In FIG. 9, "A" represents a characteristic when the dielectric layer 130 includes only the second intermediate layer 132 without the first intermediate layer 131, "B1,", "B2," "B3," "B4," "B5," and "B6" represent a characteristic when the dielectric layer 130 includes only the first intermediate layer 131 without the second intermediate layer 132, and "C1," "C2," "C3," and "C4" represent a characteristic when the dielectric layer 130 includes both the first intermediate layer 131 and the second intermediate layer 132. In addition, the content of the first intermediate layer 131 increases from "B1" to "B6" and the content of the second intermediate layer 132 increases from "C1" to "C4." The contents of the first intermediate layer 131 in the dielectric layer 130 of "B1,", "B2," "B3," "B4," "B5," and "B6" are 0 at%, 2.5 at%, 5 at%, 7.5 at%, 10 at% and 12.5 at%, respectively. The contents of the first intermediate layer 131 in the dielectric layer 130 of "C1," "C2," "C3," and "C4" are 10 at% and the contents of the second intermediate layer 132 in the dielectric layer 130 of "C1," "C2," "C3," and "C4 are 3 at%, 4.5 at%, 6 at%, and 7.5 at%, respectively. In addition, a gap between the conductive interface layer 120 and the first intermediate layer 131 is 50 % of the thickness of the dielectric layer 130 and a gap between the conductive interface layer 120 and the second intermediate layer 132 is 25 % of the thickness of the dielectric layer 130.

Referring to FIG. 9, the improvement in leakage current (LKG) may be observed even when germanium oxide (GeO₂) is provided alone in the dielectric layer 130. However, when aluminum oxide (Al₂O₃) is provided alone in the dielectric layer 130, the leakage current may be reduced as the content of aluminum oxide (Al₂O₃) increases, compared to a case where germanium oxide (GeO₂) is provided alone. However, when aluminum oxide (Al₂O₃) is provided alone in the dielectric layer 130, leakage current characteristics are improved as the content of aluminum oxide (Al₂O₃) increases, but equivalent oxide thickness (T_{oxeq}) characteristics may deteriorate. On the other hand, when aluminum oxide (Al₂O₃) and germanium oxide (GeO₂) are provided together in the dielectric layer 130, leakage current characteristics may be further improved. In addition, when aluminum oxide (Al₂O₃) and germanium oxide (GeO₂) are provided together in the dielectric layer 130, a slope at which equivalent oxide thickness characteristics deteriorate may be relatively alleviated, compared to a slope at which leakage current characteristics are improved.

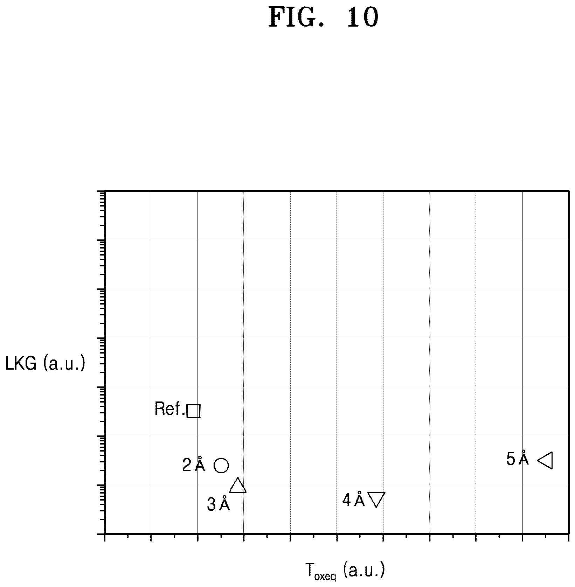

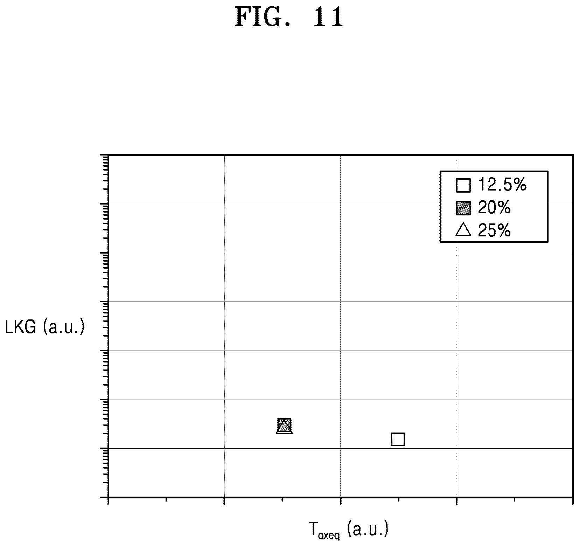

FIG. 10 is a graph showing a comparison of leakage current characteristics of the capacitor according to the thickness of the second intermediate layer 132. In addition, FIG. 11 is a graph showing a comparison of leakage current characteristics of the capacitor according to the position of the second intermediate layer 132. As in FIG. 9, in FIGS. 10 and 11, the dielectric layer 130 used titanium oxide (TiO₂) having a thickness of 5 nm, the first intermediate layer 131 used aluminum oxide (Al₂O₃), and the second intermediate layer 132 used germanium oxide (GeO₂). The first electrode 110 used titanium nitride (TiN), the first conductive interface layer 121 used molybdenum oxide (MoO₂) doped with Sn, and the second conductive interface layer 122 used tin oxide (SnO₂).

In FIG. 10, "Ref" shows characteristics of a case where the first intermediate layer 131 is provided alone without the second intermediate layer 132. Referring to FIG. 10, when the thickness of the second intermediate layer 132 is 0.2 nm (2 Å), leakage current characteristics are improved, compared to a case where the first intermediate layer 131 is provided alone. In addition, leakage current characteristics may be further improved as the thickness of the second intermediate layer 132 increases from 0.2 nm (2 Å) to 0.3 nm (3 Å). When the thickness of the second intermediate layer 132 is 0.4 nm (4 Å), a slight improvement in leakage current is observed but the equivalent oxide thickness characteristics may deteriorate, compared to a case where the thickness of the second intermediate layer 132 is 0.3 nm (3 Å). When the thickness of the second intermediate layer 132 is 0.5 nm (5 Å), leakage current characteristics are similar to those when the thickness of the second intermediate layer 132 is 0.2 nm (2 Å), and equivalent oxide thickness characteristics may further deteriorate.

By taking these characteristics into consideration, the thickness of the second intermediate layer 132 may be about 0.1 nm (1 Å) or more and about 0.5 nm (5 Å) or less, about 0.1 nm (1 Å)or more and about 0.4 nm (4 Å) or less, about 0.1 nm (1 Å) or more and about 0.3 nm (3 Å) or less, about 0.2 nm (2 Å) or more and about 0.5 nm (5 Å) or less, about 0.2 nm (2 Å) or more and about 0.4 nm (4 Å) or less, or about 0.2 nm (2 Å) or more and about 0.3 nm (3 Å) or less. The thickness of the second intermediate layer 132 may be less than the thickness of the first intermediate layer 131. The thickness of the first intermediate layer 131 may be about 1 nm (10 Å) or less.

In addition, the content of the metal of the second intermediate layer 132 having the above-described thickness in the dielectric layer 130 may be about 0.1 at% or more and about 10 at% or less. The content of the metal of the second intermediate layer 132 may be a ratio of the number of metal atoms in the second intermediate layer 132 to the total number of metal atoms in the dielectric layer 130 including the dopant metal of the first intermediate layer 131.

Referring to FIG. 11, a change in equivalent oxide thickness characteristics was observed depending on the position of the second intermediate layer 132 or a gap (see g of FIG. 1) between the conductive interface layer 120 and the second intermediate layer 132. The second intermediate layer 132 used germanium oxide (GeO₂) having a thickness of 0.2 nm. For example, when the gap g between the conductive interface layer 120 and the second intermediate layer 132 is 20 % and 25 % of the thickness of the dielectric layer 130, almost the same characteristics are observed. However, when the second intermediate layer 132 is too close to the conductive interface layer 120, equivalent oxide thickness characteristics may deteriorate. For example, when the gap g between the conductive interface layer 120 and the second intermediate layer 132 is 12.5 % of the thickness of the dielectric layer 130, leakage current characteristics may be similar but the equivalent oxide thickness may increase, compared to a case where the gap g between the conductive interface layer 120 and the second intermediate layer 132 is 20 % or more of the thickness of the dielectric layer 130. By taking this into consideration, the gap g between the conductive interface layer 120 and the second intermediate layer 132 may be 20 % or more of the thickness of the dielectric layer 130 or 25 % or more of the thickness of the dielectric layer 130. For example, the gap g between the conductive interface layer 120 and the second intermediate layer 132 may be about 0.5 nm (5 Å) or more. When the gap g between the conductive interface layer 120 and the second intermediate layer 132 is about 0.5 nm (5 Å) or more, the second intermediate layer 132 may be provided at any position in the dielectric layer 130.

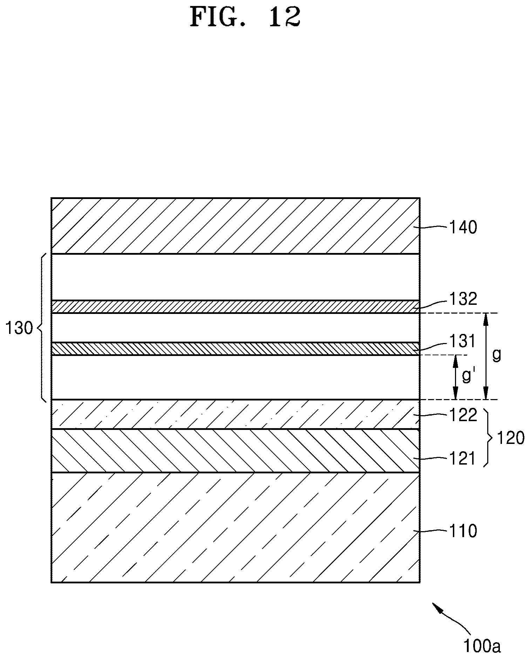

FIG. 12 is a cross-sectional view illustrating a schematic structure of a capacitor 100a according to at least one example embodiment. Although FIG. 1 illustrates that the second intermediate layer 132 is provided between the first intermediate layer 131 and the conductive interface layer 120 in the dielectric layer 130, the position of the second intermediate layer 132 is not limited thereto. Referring to FIG. 12, in the case of the capacitor 100a according to at least one example embodiment, a first intermediate layer 131 may be provided between a second intermediate layer 132 and a conductive interface layer 120 in a dielectric layer 130. In this case, a gap g between the conductive interface layer 120 and the second intermediate layer 132 may be greater than a gap g' between the conductive interface layer 120 and the first intermediate layer 131.

Alternatively, although not illustrated, the first intermediate layer 131 and the second intermediate layer 132 may be provided to overlap each other in the dielectric layer 130. In this case, the gap g between the conductive interface layer 120 and the second intermediate layer 132 may be equal to the gap g' between the conductive interface layer 120 and the first intermediate layer 131.

In addition, although FIGS. 1 and 12 illustrate that the dielectric layer 130, and the first intermediate layer 131 and the second intermediate layer 132 provided in the dielectric layer 130 are clearly distinguished for convenience, the materials of the dielectric layer 130 and the materials of the first intermediate layer 131 and the second intermediate layer 132 in the actually manufactured capacitors 100 and 100a may be mixed in the dielectric layer 130, and thus, may not be clearly distinguished. In this respect, it may be stated that the dielectric layer 130 includes a first metal oxide, a second metal oxide, and a third metal oxide.

The first metal oxide may be, for example, titanium oxide (TiO₂) having a rutile crystalline phase. The second metal oxide may be a material of the first intermediate layer 131. For example, the second metal oxide may include an oxide of at least one metal selected from aluminum (Al), gallium (Ga), yttrium (Y), lanthanum (La), boron (B), indium (In), and/or scandium (Sc). The third metal oxide may be a material of the second intermediate layer 132. For example, the third metal oxide may include an oxide of a Group IV metal element. For example, the third metal oxide may include an oxide of at least one metal selected from germanium (Ge), silicon (Si), and tin (Sn).

The content of the metal of the first metal oxide in the dielectric layer 130 may be the highest of the first, second, and/or third metal oxides, and the content of the metal of the second metal oxide may be different from the content of the metal of the third metal oxide. For example, a ratio of metal atoms of the first metal oxide to the total number of metal atoms in the dielectric layer 130 may be about 70 at% or more. In addition, a ratio of metal atoms of the second metal oxide to the total number of metal atoms in the dielectric layer 130 may be greater than 0 at% and about 20 at% or less. A ratio of metal atoms of the third metal oxide to the total number of metal atoms in the dielectric layer 130 may be about 0.1 at% or more and about 10 at% or less. In addition, the above description of the configurations, such as the thicknesses and positions of the first intermediate layer 131 and the second intermediate layer 132, may also be applied to the second metal oxide and the third metal oxide.

When the dielectric layer 130 is formed on the second conductive interface layer 122 after the process illustrated in FIG. 3D, titanium oxide (TiO₂), which is the first metal oxide, may be partially deposited through ALD. After that, the second metal oxide and the third metal oxide may be sequentially deposited, or the third metal oxide and the second metal oxide may be sequentially deposited, or the second metal oxide and the third metal oxide may be deposited simultaneously through ALD. In addition, when the second metal oxide or the third metal oxide is deposited, the first metal oxide may be deposited together. After the second metal oxide and the third metal oxide are deposited, the first metal oxide may be further deposited when necessary. In this manner, the dielectric layer 130 including the first metal oxide, the second metal oxide, and the third metal oxide may be formed on the second conductive interface layer 122.

On the other hand, the Sn doping concentration in the first conductive interface layer 121 described with reference to FIGS. 5 to 7 does not take into consideration the leakage current reduction effect by the first intermediate layer 131 and the second intermediate layer 132. When the first intermediate layer 131 and the second intermediate layer 132 are provided together in the dielectric layer 130, the Sn doping concentration range in the first conductive interface layer 121 may be further expanded. For example, the Sn doping concentration in the first conductive interface layer 121 may be about 0.1 at% or more and about 10 at% or less. Alternatively, the Sn doping concentration in the first conductive interface layer 121 may be about 0.1 at% or more and about 8 at% or less, or about 0.1 at% or more and about 6 at% or less.

As described above, in the case of the capacitors 100 and 100a according to the some example embodiments, the dielectric layer 130 including a dielectric material having a rutile crystalline phase may be formed through ALD by using the first conductive interface layer 121 doped with Sn, e.g., as a seed layer. Accordingly, the disclosed capacitors 100 and 100a may be miniaturized and have high capacitance. In addition, because the material of the first electrode 110 is chemically stable, the material of the first electrode 110 is unlikely to be reduced to a metal in a subsequent process. In addition, the leakage current may be decreased by using the second conductive interface layer 122 having a sufficiently large CBO with the dielectric layer 130. In addition, the leakage current may be further reduced by further inserting the first intermediate layer 131 and the second intermediate layer 132 into the dielectric layer 130.

The capacitor may be employed in various electronic devices. The capacitor may be used as a dynamic random access memory (DRAM) together with a transistor. In addition, the capacitor may be used for a portion of an electronic circuit constituting an electronic device together with other circuit elements.

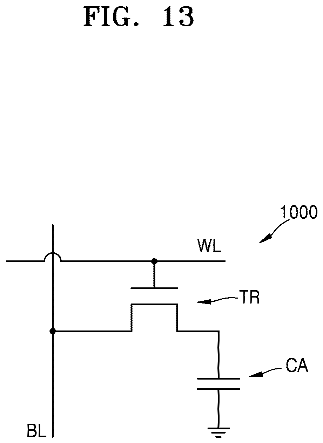

FIG. 13 is a circuit diagram for describing a schematic circuit configuration and operation of an electronic device 1000 including a capacitor, according to some example embodiments.

The circuit diagram of the electronic device 1000 is for one cell of a DRAM, and the electronic device 1000 includes one transistor TR, one capacitor CA, a word line WL, and a bit line BL. The capacitor CA may be the capacitors 100 and 100a described with reference to FIGS. 1 to 12.

A method of writing data to the DRAM is as follows. After a gate voltage (high) for turning the transistor TR on ("ON" state) is applied to a gate electrode through the word line WL, VDD (hereinafter, a high voltage) or 0 (hereinafter, a low voltage), which is a data voltage value to be input, is applied to the bit line BL. When a high voltage is applied to the word line WL and the bit line BL, the capacitor CA is charged, that is, data "1" is written. When a high voltage is applied to the word line WL and a low voltage is applied to the bit line BL, the capacitor CA is discharged, that is, data "0" is written.

Upon reading data, a high voltage is applied to the word line WL to turn on the transistor TR of the DRAM, and a voltage of VDD/2 is applied to the bit line BL. When the data of the DRAM is "1," that is, when the voltage of the capacitor CA is VDD, charges stored in the capacitor CA slowly move to the bit line BL and the voltage of the bit line BL becomes slightly higher than VDD/2. In contrast, when the data of the capacitor CA is "0," charges of the bit line BL move to the capacitor CA and the voltage of the bit line BL becomes slightly lower than VDD/2. A sense amplifier may sense and amplify the potential difference of the bit line BL and determine whether the data is "0" or "1."

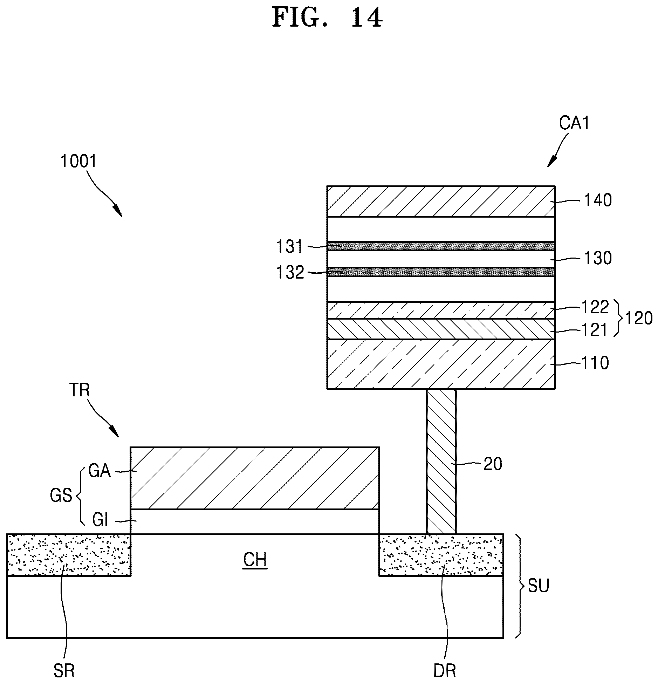

FIG. 14 is a schematic diagram illustrating an electronic device 1001 according to at least one example embodiment.

Referring to FIG. 14, the electronic device 1001 may include a structure in which a capacitor CA1 and a transistor TR are electrically connected to each other through a contact 20. The capacitor CA1 may include a first electrode 110, a second electrode 140, a dielectric layer 130 between the first electrode 110 and the second electrode 140, and a conductive interface layer 120 between the first electrode 110 and the dielectric layer 130. The capacitor CA1 may be the capacitors 100 and 100a described with reference to FIGS. 1 to 12. Because this has been described above, detailed descriptions thereof are omitted.

The transistor TR may be a field effect transistor. The transistor TR includes a semiconductor substrate SU and a gate stack GS. The semiconductor substrate SU includes a source region SR, a drain region DR, and a channel region CH. The gate stack GS is arranged on the semiconductor substrate SU and faces the channel region CH. The gate stack GS includes a gate insulating layer GI and a gate electrode GA.

The channel region CH is a region between the source region SR and the drain region DR and is electrically connected to the source region SR and the drain region DR. The source region SR may be electrically connected to or in contact with one end of the channel region CH, and the drain region DR may be electrically connected to or in contact with the other end of the channel region CH. The channel region CH may be defined as a substrate region between the source region SR and the drain region DR in the semiconductor substrate SU.

The semiconductor substrate SU may include a semiconductor material. The semiconductor substrate SU may include, for example, a semiconductor material, such as silicon (Si), germanium (Ge), silicon germanium (SiGe), silicon carbide (SiC), gallium arsenide (GaAs), indium arsenide (InAs), or indium phosphide (InP). In addition, the semiconductor substrate SU may include a silicon on insulator (SOI) substrate.

In at least some example embodiments, the source region SR, the drain region DR, and the channel region CH may each independently be formed by implanting impurities into different regions of the semiconductor substrate SU. In this case, the source region SR, the channel region CH, and the drain region DR may each include a substrate material as a base material. The source region SR and the drain region DR may each include a conductive material. In this case, the source region SR and the drain region DR may each include, for example, a metal, a metal compound, or a conductive polymer.

In at least some example embodiments, the channel region CH may be implemented as a separate material layer (thin film), unlike the illustration thereof. In this case, for example, the channel region CH may include at least one of Si, Ge, SiGe, a Group III-V semiconductor, an oxide semiconductor, a nitride semiconductor, an oxynitride semiconductor, a two-dimensional (2D) material, a quantum dot (QD), an organic semiconductor, and/or the like. For example, the oxide semiconductor may include InGaZnO or the like, the 2D material may include transition metal dichalcogenide (TMD) or graphene, and the QD may include a colloidal QD or a nanocrystal structure.

The gate electrode GA may be arranged on the semiconductor substrate SU and may face the channel region CH while being apart from the semiconductor substrate SU. The gate electrode GA may include at least one of a metal, a metal nitride, a metal carbide, and polysilicon. For example, the metal may include at least one of aluminum (Al), tungsten (W), molybdenum (Mo), titanium (Ti), and tantalum (Ta), and the metal nitride may include at least one of titanium nitride (TiN) and tantalum nitride (TaN). The metal carbide may include at least one of aluminum-doped (or aluminum-containing) metal carbide and silicon-doped (or silicon-containing) metal carbide. Specific examples of the metal carbide may include TiAlC, TaAlC, TiSiC, or TaSiC.

The gate electrode GA may have a structure in which a plurality of materials are stacked. For example, the gate electrode GA may have a structure (e.g., TiN/Al) in which a metal nitride layer and a metal layer are stacked, or a structure (e.g., TiN/TiAlC/W) in which a metal nitride layer, a metal carbide layer, and a metal layer are stacked. However, the materials described above are only an example.

The gate insulating layer GI may be further arranged between the semiconductor substrate SU and the gate electrode GA. The gate insulating layer GI may include a paraelectric material or a high-k dielectric material, and may have a dielectric constant of about 20 to about 70.

The gate insulating layer GI may include silicon oxide, silicon nitride, aluminum oxide, hafnium oxide, zirconium oxide, and/or the like, and/or may include a 2D insulator, such as hexagonal boron nitride (h-BN). For example, the gate insulating layer GI may include silicon oxide (SiO₂), silicon nitride (SiNx), and/or the like, and may include hafnium oxide (HfO₂), hafnium silicon oxide (HfSiO₄), lanthanum oxide (La₂O₃), lanthanum aluminum oxide (LaAlO₃), zirconium oxide (ZrO₂), hafnium zirconium oxide (HfZrO₂), zirconium silicon oxide (ZrSiO₄), tantalum oxide (Ta₂O₅), titanium oxide (TiO₂), strontium titanium oxide (SrTiO₃), yttrium oxide (Y₂O₃), aluminum oxide (Al₂O₃), lead scandium tantalum oxide (PbSc_{0.5}Ta_{0.5}O₃), lead zinc niobate (PbZnNbO₃), or the like. In addition, the gate insulating layer GI may include metal nitride oxide (e.g., aluminum oxynitride (AlON), zirconium oxynitride (ZrON), hafnium oxynitride (HfON), lanthanum oxynitride (LaON), yttrium oxynitride (YON), etc.), silicate (e.g., ZrSiON, HfSiON, YSiON, LaSiON, etc.), and/or aluminate (e.g., ZrAlON, HfAlON, etc.). In addition, the gate insulating layer GI may constitute a gate stack together with the gate electrode GA.

One of the first electrode 110 and the second electrode 140 of the capacitor CA1 and one of the source region SR and the drain region DR of the transistor TR may be electrically connected to each other through the contact 20. The contact 20 may include an appropriate conductive material, for example, tungsten, copper, aluminum, or polysilicon.

The arrangement of the capacitor CA1 and the transistor TR may be variously modified. For example, the capacitor CA1 may be arranged on the semiconductor substrate SU, or may be buried in the semiconductor substrate SU.

FIG. 14 illustrates that the electronic device 1001 includes one capacitor CA1 and one transistor TR, but this is only an example, and the electronic device 1001 may include a plurality of capacitors and a plurality of transistors.

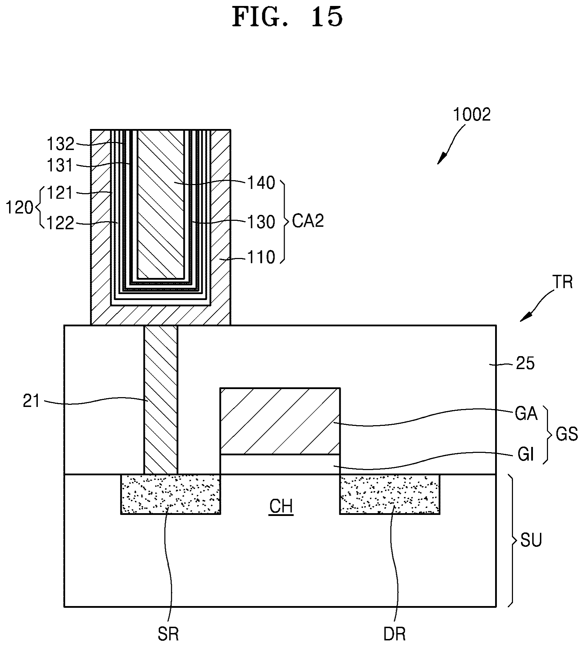

FIG. 15 is a schematic diagram illustrating an electronic device 1002 according to at least one example embodiment.

Referring to FIG. 15, the electronic device 1002 may include a structure in which a capacitor CA2 and a transistor TR are electrically connected to each other through a contact 21. The transistor TR includes a semiconductor substrate SU and a gate stack GS. The semiconductor substrate SU includes a source region SR, a drain region DR, and a channel region CH. The gate stack GS is arranged on the semiconductor substrate SU, faces the channel region CH, and includes a gate insulating layer GI and a gate electrode GA.

An interlayer insulating layer 25 may be arranged on the semiconductor substrate SU to cover the gate stack GS. The interlayer insulating layer 25 may include an insulating material. For example, the interlayer insulating layer 25 may include Si oxide (e.g., SiO₂), Al oxide (e.g., Al₂O₃), or a high-k material (e.g., HfO₂). The contact 21 passes through the interlayer insulating layer 25 to electrically connect the transistor TR to the capacitor CA2.

The capacitor CA2 includes a first electrode 110, a second electrode 140, a dielectric layer 130 between the first electrode 110 and the second electrode 140, and a conductive interface layer 120 between the first electrode 110 and the dielectric layer 130. The first electrode 110 and the second electrode 140 are provided in a shape capable of maximizing the contact area with the dielectric layer 130, and the material of the capacitor CA2 is the same as and/or substantially similar to the material of the capacitors 100 and 100a described with reference to FIGS. 1 to 12.

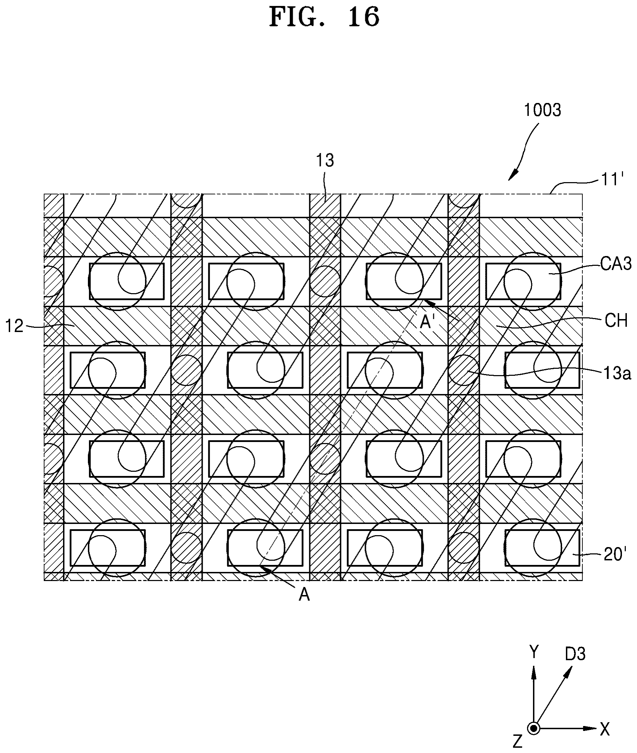

FIG. 16 is a plan view illustrating an electronic device 1003 according to at least one example embodiment.

Referring to FIG. 16, the electronic device 1003 may include a structure in which a plurality of capacitors and a plurality of field effect transistors are repeatedly arranged. The electronic device 1003 may include a field effect transistor, a contact structure 20', and a capacitor CA3. The field effect transistor includes a semiconductor substrate 11' including a source, a drain, and a channel, and a gate stack 12. The contact structure 20' is arranged on the semiconductor substrate 11' so as not to overlap the gate stack 12. The capacitor CA3 is arranged on the contact structure 20'. The electronic device 1003 may further include a bit line structure 13 electrically connecting the field effect transistors to each other.

Although FIG. 16 illustrates that both the contact structure 20' and the capacitor CA3 are repeatedly arranged in the X and Y directions, the disclosure is not limited thereto. For example, the contact structure 20' may be arranged in the X and Y directions, and the capacitor CA3 may be arranged in a hexagonal shape, such as a honeycomb structure.

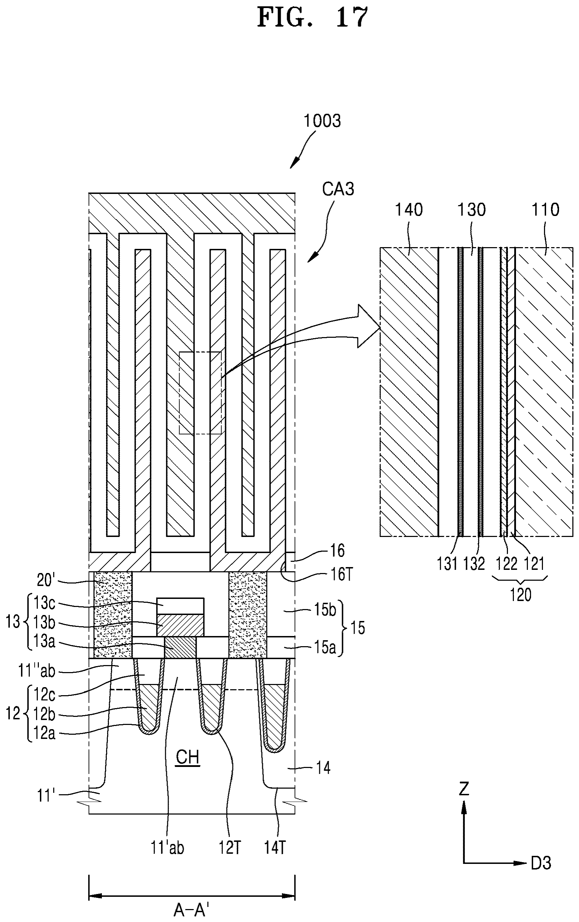

FIG. 17 is a cross-sectional view of the electronic device 1003 taken along line A-A' of FIG. 16.

Referring to FIG. 17, the semiconductor substrate 11' may have a shallow trench isolation (STI) structure including a device isolation layer 14. The device isolation layer 14 may be a single layer including one type of insulating layer, or multiple layers including a combination of two or more types of insulating layers. The device isolation layer 14 may include a device isolation trench 14T in the semiconductor substrate 11', and the device isolation trench 14T may be filled with an insulating material. The insulating material may include at least one of fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), and tonen silazene (TOSZ), but the disclosure is not limited thereto.

The semiconductor substrate 11' may further include a channel region CH defined by the device isolation layer 14, and a gate line trench 12T parallel to the upper surface of the semiconductor substrate 11' and extending in the X direction. The channel region CH may have a relatively long island shape having a minor axis and a major axis. The major axis of the channel region CH may be arranged in a D3 direction parallel to the upper surface of the semiconductor substrate 11', as illustrated in FIG. 16.

The gate line trench 12T may be arranged to cross the channel region CH at a certain depth from the upper surface of the semiconductor substrate 11', or may be arranged inside the channel region CH. The gate line trench 12T may also be arranged inside the device isolation trench 14T. The gate line trench 12T inside the device isolation trench 14T may have a lower bottom surface than that of the gate line trench 12T of the channel region CH. A first source/drain 11'ab and a second source/drain 11"ab may be arranged in an upper portion of the channel region CH located at both sides of the gate line trench 12T.

The gate stack 12 may be arranged inside the gate line trench 12T. Specifically, a gate insulating layer 12a, a gate electrode 12b, and a gate capping layer 12c may be sequentially arranged inside the gate line trench 12T. The gate insulating layer 12a and the gate electrode 12b may be the same as described above, and the gate capping layer 12c may include at least one of silicon oxide, silicon oxynitride, and silicon nitride. The gate capping layer 12c may be arranged on the gate electrode 12b to fill the remaining portion of the gate line trench 12T.

A bit line structure 13 may be arranged on the first source/drain 11'ab. The bit line structure 13 may be arranged parallel to the upper surface of the semiconductor substrate 11' and extend in the Y direction. The bit line structure 13 may be electrically connected to the first source/drain 11"ab and may include a bit line contact 13a, a bit line 13b, and a bit line capping layer 13c, which are sequentially stacked on the semiconductor substrate 11'. For example, the bit line contact 13a may include polysilicon, the bit line 13b may include a metal material, and the bit line capping layer 13c may include an insulating material, such as silicon nitride or silicon oxynitride.

Although FIG. 17 illustrates that the bit line contact 13a has a bottom surface at the same level as the upper surface of the semiconductor substrate 11', this is only an example and the disclosure is not limited thereto. For example, in at least one example embodiment, a recess formed to a certain depth from the upper surface of the semiconductor substrate 11' may be further provided. The bit line contact 13a may extend to the inside of the recess so that the bottom surface of the bit line contact 13a is lower than the upper surface of the semiconductor substrate 11'.

The bit line structure 13 may further include a bit line intermediate layer (not illustrated) between the bit line contact 13a and the bit line 13b. The bit line intermediate layer may include metal silicide, such as tungsten silicide, or metal nitride, such as tungsten nitride. In addition, a bit line spacer (not illustrated) may be further formed on a sidewall of the bit line structure 13. The bit line spacer may have a single-layer structure or a multilayer structure and may include an insulating material, such as silicon oxide, silicon oxynitride, or silicon nitride. In addition, the bit line spacer may further include an air space (not illustrated).

The contact structure 20' may be arranged on the second source/drain 11"ab. The contact structure 20' and the bit line structure 13 may be arranged on different sources/drains on the semiconductor substrate 11'. The contact structure 20' may have a structure in which a lower contact pattern (not illustrated), a metal silicide layer (not illustrated), and an upper contact pattern (not illustrated) are sequentially stacked on the second source/drain 11"ab. The contact structure 20' may further include a barrier layer (not illustrated) surrounding the side surface and the bottom surface of the upper contact pattern. For example, the lower contact pattern may include polysilicon, the upper contact pattern may include a metal material, and the barrier layer may include a conductive metal nitride.

The capacitor CA3 may be arranged on the semiconductor substrate 11' and electrically connected to the contact structure 20'. Specifically, the capacitor CA3 includes a first electrode 110 electrically connected to the contact structure 20', a second electrode 140 apart from the first electrode 110, a dielectric layer 130 between the first electrode 110 and the second electrode 140, and a conductive interface layer 120 between the first electrode 110 and the dielectric layer 130. The first electrode 110 may have a cylindrical shape or a cup shape having an internal space with a closed bottom. The second electrode 140 may have a comb shape having comb teeth extending into an internal space formed by the first electrode 110 and a region between the adjacent first electrodes 110. In addition, the dielectric layer 130 may be arranged between the first electrode 110 and the second electrode 140 so as to be parallel to the surfaces of the first electrode 110 and the second electrode 140. The conductive interface layer 120 may be arranged between the first electrode 110 and the dielectric layer 130 so as to be parallel to the surfaces of the first electrode 110 and the dielectric layer 130. Because materials of the first electrode 110, the conductive interface layer 120, the dielectric layer 130, and the second electrode 140 constituting the capacitor CA3 are substantially the same as those of the capacitors 100 and 100a described with reference to FIGS. 1 to 12, detailed descriptions thereof are omitted.

An interlayer insulating layer 15 may be further arranged between the capacitor CA3 and the semiconductor substrate 11'. The interlayer insulating layer 15 may be arranged in a space between the capacitor CA3 and the semiconductor substrate 11', in which other structures are not arranged. Specifically, the interlayer insulating layer 15 may be arranged to cover a wiring and/or electrode structure, such as the bit line structure 13, the contact structure 20', and the gate stack 12 on the semiconductor substrate 11'. For example, the interlayer insulating layer 15 may surround a wall of the contact structure 20'. The interlayer insulating layer 15 may include a first interlayer insulating layer 15a surrounding the bit line contact 13a, and a second interlayer insulating layer 15b covering the side surfaces and/or the upper surfaces of the bit line 13b and the bit line capping layer 13c.

The first electrode 110 of the capacitor CA3 may be arranged on the interlayer insulating layer 15, specifically on the second interlayer insulating layer 15b. In addition, when a plurality of capacitors CA3 are arranged, bottom surfaces of a plurality of first electrodes 110 may be separated from each other by an etch stop layer 16. In other words, the etch stop layer 16 may include an opening 16T, and the bottom surface of the first electrode 110 of the capacitor CA3 may be arranged in the opening 16T. As illustrated, the first electrode 110 may have a cylindrical shape or a cup shape having an internal space with a closed bottom. The capacitor CA3 may further include a support (not shown) that prevents the first electrode 110 from being tilted or collapsed. The support may be arranged on a sidewall of the first electrode 110.

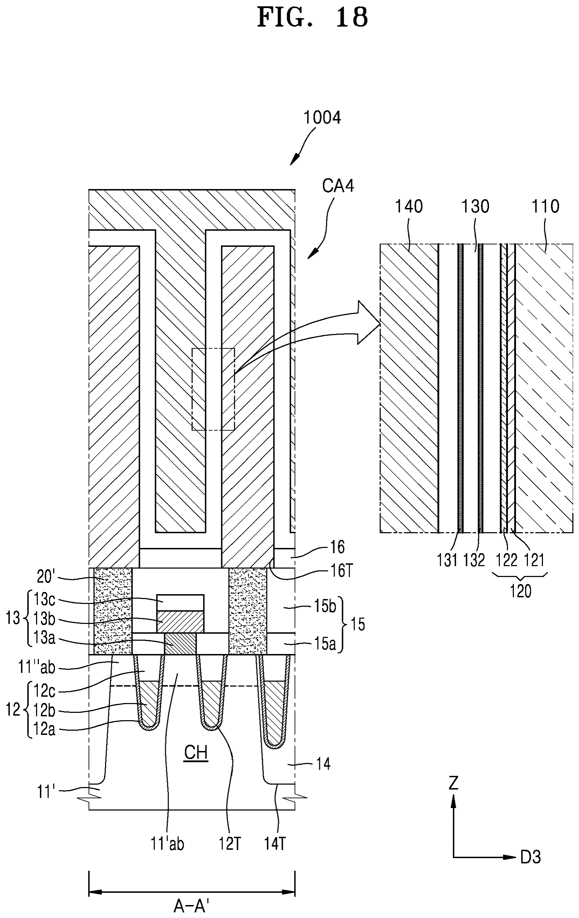

FIG. 18 is a cross-sectional view illustrating an electronic device 1004 according to at least one example embodiment.

The cross-sectional view of the electronic device 1004 according to the present embodiment corresponds to the cross-sectional view taken along line A-A' of FIG. 16, and the electronic device 1004 of FIG. 18 differs from the electronic device 1003 of FIG. 17 only in a shape of a capacitor CA4. The capacitor CA4 is arranged on a semiconductor substrate 11' and electrically connected to a contact structure 20'. The capacitor CA4 includes a first electrode 110 electrically connected to the contact structure 20', a second electrode 140 apart from the first electrode 110, a dielectric layer 130 between the first electrode 110 and the second electrode 140, and a conductive interface layer 120 between the first electrode 110 and the dielectric layer 130. Materials of the first electrode 110, the conductive interface layer 120, the dielectric layer 130, and the second electrode 140 are substantially the same as those of the capacitors 100 and 100a described with reference to FIGS. 1 to 12.

The first electrode 110 may have a pillar shape, such as a cylinder, a square pillar, or a polygonal pillar, which extends in the vertical direction (Z direction). The second electrode 140 may have a comb shape having comb teeth extending into a region between the adjacent first electrodes 110. The dielectric layer 130 may be arranged between the first electrode 110 and the second electrode 140 so as to be parallel to the surfaces of the first electrode 110 and the second electrode 140. The conductive interface layer 120 may be arranged between the first electrode 110 and the dielectric layer 130 so as to be parallel to the surfaces of the first electrode 110 and the dielectric layer 130.

The capacitors and the electronic devices according to some example embodiments described above may be applied to various application fields. For example, the electronic devices according to some example embodiments may be applied as logic devices or memory devices. The electronic devices according to some example embodiments may be used for arithmetic operations, program execution, temporary data retention, and the like in devices such as mobile devices, computers, laptop computers, sensors, network devices, and neuromorphic devices. In addition, the electronic devices according to some example embodiments may be useful for devices in which an amount of data transmission is large and data transmission is continuously performed.

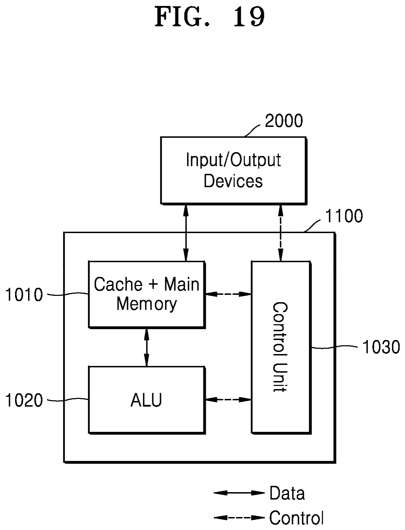

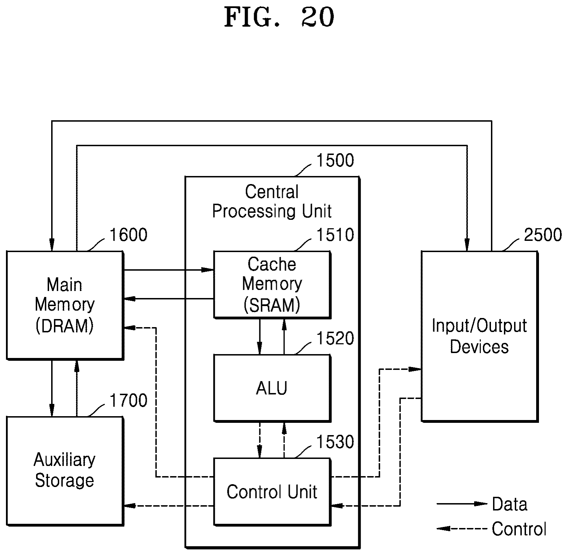

FIGS. 19 and 20 are conceptual diagrams schematically illustrating a device architecture applicable to a device according to at least one example embodiment.

Referring to FIG. 19, an electronic device architecture 1100 may include a memory unit 1010, an arithmetic logic unit (ALU) 1020, and a control unit 1030. The memory unit 1010, the ALU 1020, and the control unit 1030 may be electrically connected to each other. For example, the electronic device architecture 1100 may be implemented as a single chip including the memory unit 1010, the ALU 1020, and the control unit 1030.

The memory unit 1010, the ALU 1020, and the control unit 1030 may be interconnected in an on-chip manner via a metal line to perform direct communication. The memory unit 1010, the ALU 1020, and the control unit 1030 may be monolithically integrated on a single substrate to constitute a single chip. Input/output devices 2000 may be connected to the electronic device architecture (chip) 1100. In addition, the memory unit 1010 may include both a main memory and a cache memory. The electronic device architecture (chip) 1100 may be an on-chip memory processing unit. The memory unit 1010 may include the capacitor and the electronic device including the same, which have been described above. The ALU 1020 or the control unit 1030 may also include the capacitor described above.

Referring to FIG. 20, a cache memory 1510, an ALU 1520, and a control unit 1530 may constitute a central processing unit (CPU) 1500. The cache memory 1510 may include a static random-access memory (SRAM). Apart from the CPU 1500, a main memory 1600 and an auxiliary storage 1700 may be provided. The main memory 1600 may be a DRAM and may include the capacitor described above. In some cases, the electronic device architecture may be implemented in a form in which computing unit elements and memory unit elements are adjacent to each other on a single chip, without distinction of sub-units.

The example embodiments described above may be summarized as follows, but are not limited thereto.
(1) A capacitor according to at least one example embodiment may include a first electrode, a second electrode facing the first electrode, a dielectric layer between the first electrode and the second electrode, and a conductive interface layer between the first electrode and the dielectric layer, wherein the dielectric layer may include a dielectric material having a rutile crystalline phase, the dielectric layer may include a first intermediate layer and a second intermediate layer which are provided in the dielectric layer, the first intermediate layer may include an oxide of at least one metal selected from aluminum (Al), gallium (Ga), yttrium (Y), lanthanum (La), boron (B), indium (In), and scandium (Sc), and the second intermediate layer includes an oxide of a Group IV metal element having a rutile crystalline phase.
(2) The dielectric layer may include, for example, titanium oxide (TiO₂) having a rutile crystalline phase.
(3) A content of a metal of the first intermediate layer in the dielectric layer may be greater than 0 at% and about 20 at% or less.
(4) The second intermediate layer may include an oxide of at least one of germanium (Ge), silicon (Si), or tin (Sn).
(5) A content of a metal of the second intermediate layer in the dielectric layer may be, for example, about 0.1 at% or more and about 10 at% or less.
(6) The second intermediate layer may have a thickness of, for example, about 0.1 nm or more and about 0.5 nm or less.
(7) A thickness of the second intermediate layer may be less than a thickness of the first intermediate layer.
(8) A gap between the conductive interface layer and the second intermediate layer may be, for example, 0.5 nm or more.
(9) In an example, the second intermediate layer may be provided between the first intermediate layer and the conductive interface layer in the dielectric layer.
(10) In another example, the first intermediate layer may be provided between the second intermediate layer and the conductive interface layer in the dielectric layer.
(11) The conductive interface layer may include a first conductive interface layer between the first electrode and the dielectric layer, and a second conductive interface layer between the first conductive interface layer and the dielectric layer, the first conductive interface layer may include a conductive metal oxide material having a stable crystal structure in a rutile crystalline phase, and a conduction band offset between the second conductive interface layer and the dielectric layer may be greater than a conduction band offset between the first conductive interface layer and the dielectric layer.
(12) The first conductive interface layer may include molybdenum oxide (MoO₂) doped with tin (Sn).
(13) An Sn doping concentration in the first conductive interface layer may be, for example, about 0.1 at% or more and about 10 at% or less.
(14) The first conductive interface layer may have a thickness of, for example, about 0.3 nm or more and about 4 nm or less.
(15) The second conductive interface layer may include a conductive metal oxide material having a stable crystal structure in a rutile crystalline phase.
(16) The second conductive interface layer may include tin oxide (SnO₂), germanium oxide (GeO₂), or a mixture ((SnₓGe₁₋ₓ)O₂, 0<x<1) of tin oxide and germanium oxide.
(17) The second conductive interface layer may have a thickness of, for example, about 0.3 nm or more and about 1 nm or less.
(18) The first electrode may include at least one conductive metal nitride selected from titanium nitride (TiN), vanadium nitride (VN), niobium nitride (NbN), tantalum nitride (TaN), molybdenum nitride (MoN), and cobalt nitride (CoN), or any combination thereof.
(19) An electronic device according to at least one example embodiment may include a transistor and a capacitor electrically connected to the transistor, wherein the capacitor may include a first electrode, a second electrode facing the first electrode, and a dielectric layer between the first electrode and the second electrode, the dielectric layer may include a dielectric material having a rutile crystalline phase, the dielectric layer may include a first intermediate layer and a second intermediate layer which are provided in the dielectric layer, the first intermediate layer may include an oxide of at least one metal selected from aluminum (Al), gallium (Ga), yttrium (Y), lanthanum (La), boron (B), indium (In), and scandium (Sc), and the second intermediate layer may include an oxide of a Group IV metal element having a rutile structure.
(20) An electronic device according to at least one example embodiment may include a transistor and a capacitor electrically connected to the transistor, wherein the capacitor may include a first electrode, a second electrode facing the first electrode, and a dielectric layer between the first electrode and the second electrode, the dielectric layer may include a first metal oxide, a second metal oxide, and a third metal oxide, the first metal oxide may include titanium oxide having a rutile crystalline phase, the second metal oxide may include an oxide of at least one metal selected from aluminum (Al), gallium (Ga), yttrium (Y), lanthanum (La), boron (B), indium (In), and scandium (Sc), and the third metal oxide may include an oxide of at least one metal selected from germanium (Ge), silicon (Si), and tin (Sn).
(21) A content of the second metal oxide and a content of the third metal oxide in the dielectric layer may be different from each other.
(22) A method of manufacturing a capacitor, according to at least one example embodiment, may include forming a conductive interface layer on a first electrode, forming a dielectric layer on the conductive interface layer, the dielectric layer including a first metal oxide, a second metal oxide, and a third metal oxide, and forming a second electrode on the dielectric layer, wherein the first metal oxide may include titanium oxide having a rutile crystalline phase, the second metal oxide may include an oxide of at least one metal selected from aluminum (Al), gallium (Ga), yttrium (Y), lanthanum (La), boron (B), indium (In), and scandium (Sc), and the third metal oxide may include an oxide of at least one metal selected from germanium (Ge), silicon (Si), and tin (Sn).

In the case of the disclosed capacitor, the dielectric material of the rutile crystalline phase having a high dielectric constant may be formed by forming the conductive interface layer having the multilayer structure on the first electrode and then forming the dielectric layer on the conductive interface layer. Accordingly, the disclosed capacitor may be miniaturized and have high capacitance. In addition, according to the disclosed example embodiments, leakage current may be reduced by using the conductive interface layer having the multilayer structure.

In addition, because the dielectric layer of the capacitor according to some example embodiments include the intermediate layer capable of capturing oxygen vacancies in the dielectric layer, the leakage current may be further reduced by suppressing Fermi-level pinning.

It should be understood that some example embodiments have been described herein and the embodiments should be considered in a descriptive sense only and not for purposes of limitation. Descriptions of features or aspects within each embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A capacitor comprising:
a first electrode;
a second electrode facing the first electrode;
a dielectric layer between the first electrode and the second electrode, the dielectric layer comprising a dielectric material having a rutile crystalline phase; and
a conductive interface layer between the first electrode and the dielectric layer,
wherein the dielectric layer comprises a first intermediate layer and a second intermediate layer in the dielectric material,
the first intermediate layer comprises an oxide of at least one of aluminum (Al), gallium (Ga), yttrium (Y), lanthanum (La), boron (B), indium (In), or scandium (Sc), and
the second intermediate layer comprises an oxide of a Group IV metal element having a rutile crystalline phase.

2. The capacitor of claim 1, wherein the dielectric material of the dielectric layer comprises titanium oxide (TiO₂) having the rutile crystalline phase.

3. The capacitor of claim 1 or 2, wherein a content of a metal of the first intermediate layer in the dielectric layer is greater than 0 atomic percentage (at%) and 20 at% or less.

4. The capacitor of any preceding claim, wherein the oxide of the second intermediate layer comprises at least one of germanium (Ge), silicon (Si), or tin (Sn), and optionally wherein a content of a metal of the second intermediate layer in the dielectric layer is 0.1 atomic percentage (at%) or more and 10 at% or less.

5. The capacitor of claim 4, wherein the second intermediate layer has a thickness of 0.1 nanometers (nm) or more and 0.5 nm or less.

6. The capacitor of claim 4 or 5, wherein a thickness of the second intermediate layer is less than a thickness of the first intermediate layer.

7. The capacitor of any of claims 4 to 6, wherein a gap between the conductive interface layer and the second intermediate layer is 0.5 nanometers (nm) or more.

8. The capacitor of any preceding claim, wherein ether: the second intermediate layer is between the first intermediate layer and the conductive interface layer; or the first intermediate layer is between the second intermediate layer and the conductive interface layer.

9. The capacitor of any preceding claim, wherein
the conductive interface layer comprises a first conductive interface layer between the first electrode and the dielectric layer and a second conductive interface layer between the first conductive interface layer and the dielectric layer,
the first conductive interface layer includes a conductive metal oxide material having a stable crystal structure in a rutile crystalline phase, and
a conduction band offset (CBO) between the second conductive interface layer and the dielectric layer is greater than a CBO between the first conductive interface layer and the dielectric layer, and optionally wherein the first conductive interface layer comprises molybdenum oxide (MoO₂) doped with tin (Sn).

10. The capacitor of claim 9, wherein an Sn doping concentration in the first conductive interface layer is 0.1 at% or more and 10 at% or less.

11. The capacitor of claim 9 or 10, wherein the first conductive interface layer has a thickness of 0.3 nanometers (nm) or more and 4 nm or less.

12. The capacitor of any of claims 9 to 11, wherein the second conductive interface layer comprises tin oxide (SnO₂), germanium oxide (GeO₂), or a mixture ((SnₓGe₁₋ₓ)O₂, 0<x<1) of tin oxide and germanium oxide.

13. The capacitor of any of claims 9 to 12, wherein the second conductive interface layer has a thickness of 0.3 nanometers (nm) or more and 1 nm or less.

14. An electronic device comprising
a transistor; and
a capacitor according to any preceding claim electrically connected to the transistor.

15. A method of manufacturing a capacitor, the method comprising:
forming a conductive interface layer on a first electrode;
forming a dielectric layer on the conductive interface layer, the dielectric layer comprising a first metal oxide, a second metal oxide, and a third metal oxide; and
forming a second electrode on the dielectric layer,
wherein the first metal oxide comprises titanium oxide having a rutile crystalline phase,
the second metal oxide comprises an oxide of at least one of aluminum (Al), gallium (Ga), yttrium (Y), lanthanum (La), boron (B), indium (In), or scandium (Sc), and
the third metal oxide comprises an oxide of at least one of germanium (Ge), silicon (Si), or tin (Sn).
